# EUROPEAN PATENT APPLICATION

(11) **EP 0 842 789 A1**
(43) Date of publication of application: **20.05.1998**
(21) Application number: 97120046.4
(22) Date of filing: 15.11.1997
(51) Int. Cl.: B41M 5/38, G03C 8/40, G03F 7/34

(54) **Thermal image forming method using light**

(30) Priority: 19.11.1996 JP 307920/96
(71) Applicant: KONICA CORPORATION, Tokyo (JP)
(72) Inventor: Kobayashi, Yasunobu, Hino-shi, Tokyo (JP)
(74) Representative: Türk, Gille, Hrabal, Leifert

(57) **Abstract**

Disclosed is an image forming method comprising the steps of imagewise exposing a heat sensitive image forming material in a sheet form to a high density energy light, the material comprising an imaging sheet having an image forming layer on a first support and a peeling sheet having an adhesion layer on a second support, the imaging sheet being laminated on the peeling sheet so that the image forming layer is in contact with the adhesion layer, and a weak adhesion portion or a non-contact portion being provided at the leading edge in a transport direction; inserting a claw at the weak adhesion portion or non-contact portion between the imaging sheet and the peeling sheet; and separating the imaging sheet from the peeling sheet to form an image on the imaging sheet.

## Description

### FIELD OF THE INVENTION

The present invention relates to an image forming method using an image forming material which gives an image with a high density and a high resolving power.

### BACKGROUND OF THE INVENTION

The recording method is well known which comprises the steps of exposing to a high density energy light such as a laser light, an image forming material, whereby a part of the material is deformed, released, burnt or evaporated and removed (hereinafter referred to as ablation). This method is a dry process in which a processing solution containing a chemical is not employed, and only the exposed portions are melt-deformed, released or evaporated, which has an advantage resulting in high contrast. This method is used for an optical recording material such as a resist material, an optical disc or an image forming material obtaining a visual image.

Japanese Patent O.P.I. Publication Nos. 59-5447, 59-10563, and 62-115153 disclose a method in which a binder resin is photo-degraded by a pattern exposure to form a resist. Japanese Patent O.P.I. Publication Nos. 55-132536, 57-27788, and 57-103137 disclose a method in which a thin inorganic compound layer provided by evaporation-deposit is exposed to record information by melt-deformation. Japanese Patent O.P.I. Publication Nos. 64-56591, 1-99887, and 6-40163 disclose a method in which a colored binder resin is removed by light heat conversion to record information, and U.S. Patent No. 4,245,003 disclose an image forming material comprising an image forming layer containing graphite or carbon black.

In the above US Patent is disclosed an image forming material comprising an image receiving material provided on an image forming layer, wherein the image forming layer at exposed (ablated) portions is removed by separating the image receiving material from the image forming layer. However, in this reference there is no special disclosure of the separating method. When the image receiving material has the same size as the image forming layer, the image receiving material is difficult to separate. Further, particularly when carrying out mechanical separation in an image forming processor, the processor is complex, resulting in unstable separating.

In Japanese Patent O.P.I. Publication Nos. 52-26538, 52-131015, 52-132615 and 54-27423 is a method in which an edge for separating is provided on an image forming material to make the separating easy, but has a problem in separating with ease and with certainty.

### SUMMARY OF THE INVENTION

In view of the above, the present invention has been made. An object of the invention is to provide a method of imagewise exposing a heat sensitive image forming material in a sheet form comprising an imaging sheet and a peeling sheet to a high density energy light; and separating the imaging sheet from the peeling sheet to form an image with high density and high resolving power on the imaging sheet, wherein separating is carried out with ease and certainty.

### BRIEF EXPLANATION OF THE DRAWINGS

Fig. 1 shows one embodiment of the image forming material in the invention.

Fig. 2 shows another embodiment of the image forming material in the invention.

Fig. 3 shows a separating mechanism employing a claw.

Fig. 4 (1) shows a separating mechanism employing an adsorption roller.

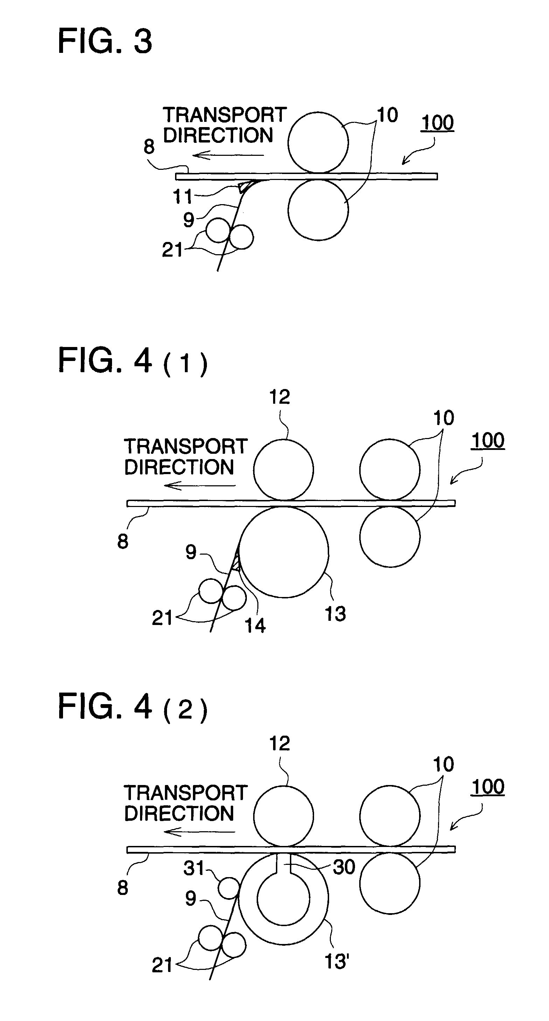

Fig. 4 (2) shows a separating mechanism employing a hollow adsorption roller.

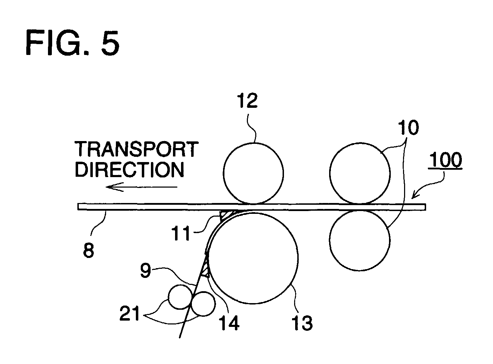

Fig. 5 shows a separating mechanism employing a claw and an adsorption roller.

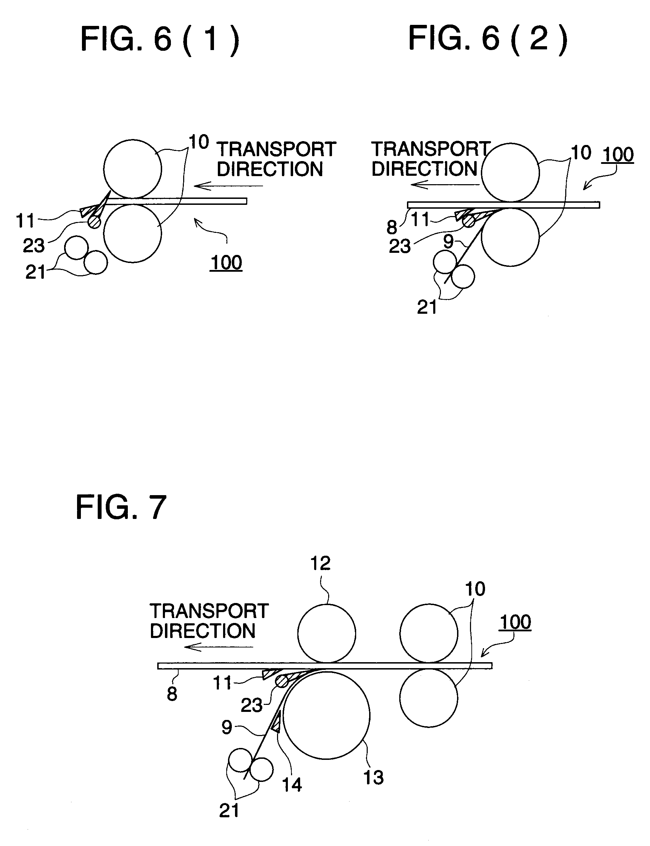

Fig. 6 shows a separating mechanism employing an image forming material having a cutout.

Fig. 7 shows a separating mechanism employing a claw and an adsorption roller, when an image forming material with a cutout is used.

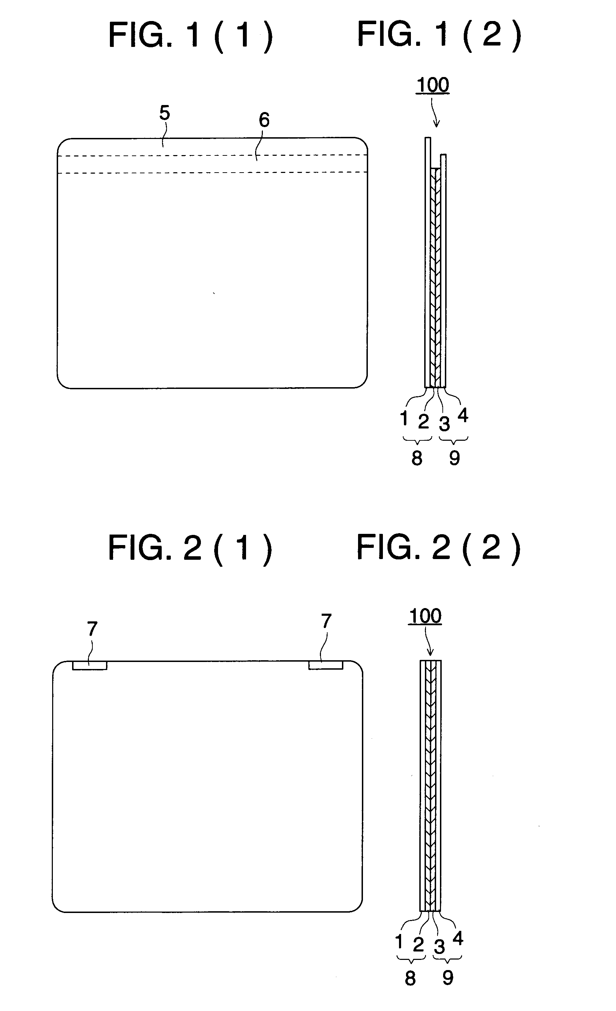

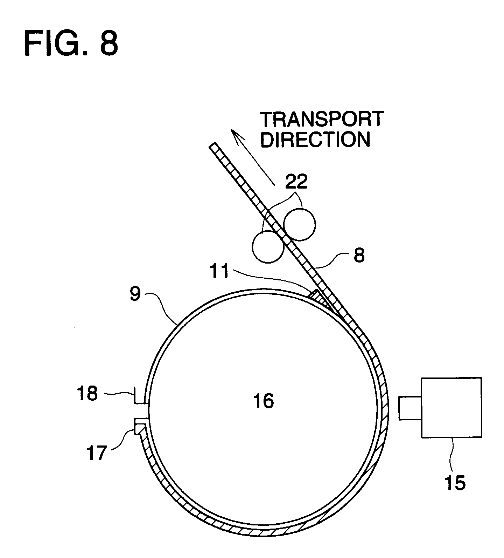

Fig. 8 shows a separating mechanism in which separating is carried out on the drum on which the image forming material of Fig. 1 is provided.

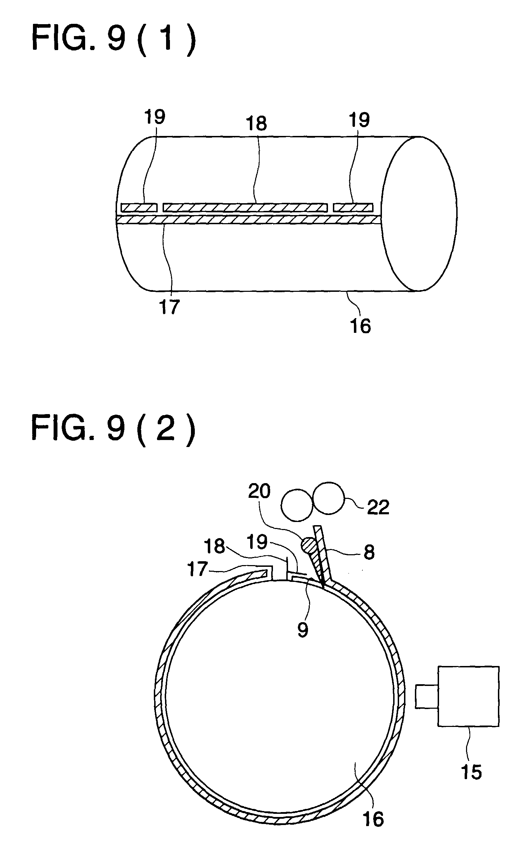

Fig. 9 shows a separating mechanism in which separating is carried out on the drum on which the image forming material of Fig. 3 is provided.

### DETAILED DESCRIPTION OF THE INVENTION

The above object of the invention can be attained by the following constitution:
1. an image forming method comprising the steps of imagewise exposing a heat sensitive image forming material in a sheet form to a high density energy light, the material comprising an imaging sheet having a colorant layer on a first support and a peeling sheet having an adhesion layer on a second support, the imaging sheet being laminated on the peeling sheet so that the colorant layer is in contact with the adhesion layer, and a weak adhesion portion or a non-contact portion being provided at the edge perpendicular to the transport direction; inserting a claw between the imaging sheet and the peeling sheet; and separating the peeling sheet from the imaging sheet to form an image on the imaging sheet, or the image forming method described above, wherein the imaging sheet is different in length in the transport direction from the peeling sheet,
2. an image forming method comprising the steps of imagewise exposing a heat sensitive image forming material in a sheet form to a high density energy light, the material comprising an imaging sheet having a colorant layer on a first support and a peeling sheet having an adhesion layer on a second support, the imaging sheet being laminated on the peeling sheet so that the colorant layer is in contact with the adhesion layer, and a cutout being provided at the edge perpendicular to the transport direction of at least one of the imaging sheet and the peeling sheet; pushing the cutout to create a space between the imaging sheet and the peeling sheet; and separating the peeling sheet from the imaging sheet to form an image on the imaging sheet,
3. the image forming method of item 1 or 2 above, wherein the separating is carried out by bringing the peeling sheet of the image forming material into contact with an adsorption roller or an adhesion roller and rotating the roller, or the image forming method of item 1, 2 or 3 above, wherein the image forming material comprises a layer capable of being ablated on exposure of a high density energy light,
4. an image forming method comprising the steps of imagewise exposing a heat sensitive image forming material in a sheet form to light, the material comprising an imaging sheet having an image forming layer on a first support and a peeling sheet having an adhesion layer on a second support, the imaging sheet being laminated on the peeling sheet so that the image forming layer is in contact with the adhesion layer, and a weak adhesion portion or a non-contact portion being provided at the leading edge in a transport direction; inserting a claw at the weak adhesion portion or non-contact portion between the imaging sheet and the peeling sheet; and separating the imaging sheet from the peeling sheet to form an image on the imaging sheet,
5. an image forming method comprising the steps of imagewise exposing a heat sensitive image forming material in a sheet form to a high density energy light, the material comprising an imaging sheet having an image forming layer on a first support and a peeling sheet having an adhesion layer on a second support, the imaging sheet being laminated on the peeling sheet so that the image forming layer is in contact with the adhesion layer, and a cutout being provided at the leading edge in a transport direction of at least one of the imaging sheet and the peeling sheet; pushing the cutout to create a space between the imaging sheet and the peeling sheet; and separating the imaging sheet from the peeling sheet to form an image on the imaging sheet,
6. The image forming method of item 5 above, wherein the cutout is provided at the imaging sheet, or
7. The image forming method of item 5 or 6 above, wherein the separating is carried out by inserting a claw at the space between the imaging sheet and the peeling sheet.

The present invention will be explained below.

### (Image forming material)

The imaging sheet in the invention comprises a first support and provided thereon, an image forming layer.

### (First Support)

The first support includes a transparent support including a resin film such as polyacrylate, polymethacrylate, polyethyleneterephthalate, polybutyleneterephthalate, polyethylenenaphthalate, polycarbonate, polyvinyl chloride, polyethylene, polypropylene, polystyrene, nylon, aromatic polyamide, polyether etherketone, polysulfone, polyether sulfone, polyimide or polyether imide, or a film in which the above two or more resin films are laminated. The transparent support herein referred to implies a support capable of transmitting light of light source port. The support is preferably obtained by orienting resins in the film form and heat-setting in view of dimensional stability. The support may contain a filler such as titanium oxide, zinc oxide, barium sulfate or calcium carbonate, as long as it does not inhibit image formation. The support may contain a blue dye in order to produce a blue color. The thickness of the support in the invention is 10 to 500 µm, and preferably 25 to 250 µm.

The first support used in the invention may be modified according to a conventional surface improving technique such as corona discharge or anchor coating in order to improve adhesion property or coatability, or a backing layer may be provided on a support opposite the image forming layer to prevent static charge, improve transportability or prevent plural paper feeding, as long as the effect of the invention is not inhibited. The thickness of the anchor coat layer or the backing layer is preferably 0.001 to 10 µm, and more preferably 0.005 to 5 µm. An anti-static back-coat layer or a colored back-coat layer may be further provided, as long as the effect of the invention is not inhibited.

### (Image forming layer)

The image forming layer may be a layer comprised of a light heat converting layer and a colorant layer, a layer comprised of plural light heat converting layers and plural colorant layers, or a layer comprised of a colorant layer. The image forming layer is preferably a colorant layer.

The colorant in the image forming layer can be used without any limitations, so long as they can cause ablation at exposed portions (reduce an adhesion force between the image forming layer and the support). In order to effectively reduce the adhesion force at the exposed portions and improve image sharpness, a light-heat converting substance or a compound having an absorption in the wavelength of from 300 to 800 nm are preferably used and can be used singly or in combination of two kinds or more, respectively. When the compound having an absorption in the wavelength of from 300 to 800 nm can act as a light-heat converting substance, the compound can be used as a colorant.

Such a light-heat converting substance includes organic compounds such as a dye having an absorption in the wavelength range of 600 to 1200 nm or dyes (for example, cyanine dyes, rhordanine dyes, oxonol dyes, carbocyanine dyes, dicarbocyanine dyes, tricarbocyanine dyes, tetracarbocyanine dyes, pentacarbocyanine dyes, styryl dyes, pyrilium dyes, phthalocyanine dyes, metal-containing dyes or compounds disclosed in Chem. Rev. 92, 1197 (1992)), and inorganic compounds (for example, graphite, carbon black, tricobalt tetroxide, ferric oxide, chromium oxide, copper oxide and titanium black).

As the compound having an absorption in the wavelength range of 300 to 800 nm, the same organic compound and/or inorganic compound as the light-heat converting substance can be used. The organic compound includes various dyes or pigments which are well known, and the inorganic compound includes inorganic pigment, metal oxide powder, metal nitride powder, metal carbide powder and metal sulfide powder which are well known. Further, various magnetic powder can be suitably used.

Of the above colorants which are used as a light heat converting substance having an absorption in the wavelength range of 300 to 800 nm, a non-porous colorant dispersed in the image forming layer is preferable, since the remained rate of the image forming layer at exposed portions to be removed is small. Such a colorant includes an inorganic metal compound having an absorption in the wavelength range of 300 to 800 nm, such as metal oxide powder, metal nitride powder, metal carbide powder and magnetic powder. In order to obtain high resolving power, the size of the powders is preferably not more than 0.5 µm, and more preferably not more than 0.3 µm.

For example, when the magnetic powder is used, ferromagnetic ferric oxide powder, ferromagnetic metal powder and cubic, tabular powder are used, and ferromagnetic metal powder is suitably used. The average major axial length of the ferromagnetic powder is usually not more than 0.30 µm, and preferably not more than 0.20 µm. Employing such a ferromagnetic powder, an image is obtained in which the remained rate of the image forming layer at ablated portions is reduced, and the surface property of the image forming layer is improved.

The colorant content of the image forming layer is 10 to 99 weight %, and preferably 30 to 95 weight %.

A binder used in the image forming layer includes vinyl chloride resins such as vinyl chloride-vinyl acetate copolymers, polyolefins such as butadien-acrylonitrile copolymers, polyvinyl acetals such as polyvinyl butyrals, cellulose derivatives including nitrocellulose, styrene resins such as styrene-butadiene copolymers, acryl resins such as acrylate resins, polyamide resins, phenolic resins, epoxy resins, and phenoxy resins.

An image forming layer coating solution containing the colorant described above may be coated on a transparent support, and then hardened to obtain an imaging sheet. The hardening is carried out according to a conventional method including heat hardening, active energy ray hardening or moisture hardening. Sufficient hardening is preferably carried out by means of heat application or active energy ray radiation.

The heat hardenable resin and optionally added hardening agent include a binder resin having a hydroxy, carboxy or sulfonic acid group and a hardening agent having an isocyanate group, a binder resin having an epoxy group and a hardening agent, a binder resin having an amino group and a hardening agent, and a binder resin having an acid anhydride group and a hardening agent, respectively. The resin capable of being hardened with a catalyst can be also used.

The binder content of the image forming layer is 1-90 weight %, and preferably 5-70 weight %. The content of the hardening agent or catalyst is ordinarily 0.1-200 weight parts, and preferably 0.5-100 weight parts based on the 100 weight parts of the heat hardenable resin.

In the active energy ray hardening method, a combination of a conventional compound having an ethylenically unsaturated double bond or an epoxy group with a polymerization initiator can be used.

Besides the above components, the image forming layer may contain additives such as lubricants, durability improvers, dispersing agents, anti-static agents, and fillers.

The lubricants include fatty acids, fatty esters, fatty acid amide, (modified) silicone oils, (modified) silicone resins, fluorinated resins, and fluorinated carbons, and durability improvers include polyisocyanates.

The dispersing agents include fatty acids having 12 to 18 carbon atoms such as lauric acid and stearic acid or their amides, alkali metal salts or alkali earth metal salts, polyalkyleneoxide alkyl phosphates, lecithin, trialkyl polyolefinoxy quaternary ammonium salts and azo compounds having a carboxy group or a sulfo group. The heat hardenable resin, active energy ray hardenable resin or binder resin containing a polar group selected from the group consisting of -SO₃M, -OSO₃M, -COOM and -PO(OM₁)₂ (wherein M represents a hydrogen atom or an alkali atom; and M₁ represents a hydrogen atom, an alkali atom or an alkyl group) can be used as dispersing agents.

The antistatic agents include a cationic surfactant, an anionic surfactant, a nonionic surfactant, a polymeric antistatic agent and conductive fine particles, and compounds described on pages 875 and 876, 11290 Chemicals, edited by Kagaku Kogyo Nippo Co. Ltd. The fillers include inorganic fillers such as carbon black, graphite, TiO₂, barium sulfate, ZnS, MgCO₃, CaCO₃, ZnO, CaO, WS₂, MoS₂, MgO, SnO₂, SiO₂, Al₂O₃, α-Fe₂O₃, α-FeOOH, SiC, CeO₂,, BN, SiN, MoC, BC, WC, titanium carbide, corundum, artificial diamond, garnet, tripoli, diatomaceous earth, dolomite, and organic fillers such as polyethylene resin particles, fluorine-containing resin particles, guanamine resin particles, acryl resin particles, silicone resin particles, and melamine resin particles.

The additive content of the image forming layer is 0 to 20 weight %, and preferably 0 to 15 weight %. The thickness of the image forming layer is 0.05 to 5.0 µm, and preferably 0.1 to 3.0 µm.

The peeling sheet in the invention comprises a second support and provided thereon, an adhesion layer.

### (Second Support)

The second support includes a support including a resin film such as polyacrylate, polymethacrylate, polyethyleneterephthalate, polybutyleneterephthalate, polyethylenenaphthalate, polycarbonate, polyvinyl chloride, polyethylene, polypropylene, polystyrene, nylon, aromatic polyamide, polyether etherketone, polysulfone, polyether sulfone, polyimide or polyether imide, or a film in which the above two or more resin films are laminated. The second support may be transparent or translucent. The resin for the second support may be a foamed resin to give affinity to the first support or to give a cushioning property to absorb concavities and protrusions of the drum surface. The support is preferably obtained by orienting resins in the film form and heat-setting in view of dimensional stability. The support may contain a filler such as titanium oxide, zinc oxide, barium sulfate or calcium carbonate, as long as it does not inhibit image formation. The thickness of the second support in the invention is 5 to 100 µm, and preferably 10 to 80 µm. As long as the effect of the invention is not inhibited, the second support may be modified according to a conventional surface improving technique such as corona discharge or anchor coating in order to improve adhesion property or coatability, or a backing layer may be provided on a support opposite the image forming layer to prevent static charge, improve transportability or prevent plural paper feeding. The thickness of the anchor coat layer or the backing layer is preferably 0.001 to 10 µm, and more preferably 0.005 to 5 µm. The backing layer with anti-static property may be further provided.

### (Adhesion layer)

The adhesion layer may be a layer itself having adhesion property, or a layer producing adhesion property by applying heat or pressure, and can be formed using, for example, a low softening point resin, an adhesive or a heat solvent.

The low softening point resin includes an ethylene copolymer such as ethylene-vinylacetate copolymer or ethylene-ethylacrylate copolymer, a polystyrene resin such as styrene-butadiene copolymer, styrene-isoprene copolymer, or styrene-ethylene-butylene copolymer, a polyester resin, a polyurethane resin, a polyolefin resin such as polyethylene or polypropylene, a polyvinyl ether resin, a polyacrylate resin such as polybutylmethacrylate, an ionomer resin, a cellulose, an epoxy resin, a polyvinyl chloride resin such as copolyvinylchloride-vinylacetate, polyvinyl alcohol and a polyvinyl alcohol derivative such as polyvinyl butyral. The adhesive includes modified or non-modified rosins such as rosin, hydrogenated rosin, rosin-maleic acid, polymeric rosin and rosin phenol, and terpenes and petroleum resins or their modified resins The heat solvent includes compounds which are solid at ordinary temperature and thermally reversibly liguefies or softens, concretely, monomolecular compounds such as terpineol, menthol, acetoamide, benzamide, cumarine, benzyl cinnamate, diphenylether, crown ether, camphor, p-methylacetophenone, vanillin, dimethoxybenzaldehyde, p-benzyldiphenyl, stilbene, margaric acid, eicosanol, cetylpalmitate, stearic amide, and behenylamine, waxes such as bees wax, candelilla wax, paraffin wax, ester wax, montan wax, carnauba wax, amide wax, polyethylene wax and microcrystalline wax, rosin derivatives such as ester gum, rosin-maleic acid resins and rosin phenol resins, a phenol resin, a ketone resin, an epoxy resin, a diallylphthalate resin, a terpene type hydrocarbon resin, a cyclopentadiene resin, a polyolefin resin, a polycaprolactam resin, and polyethylene oxides such as polyethylene glycol and polypropylene glycol.

The thickness of the adhesion layer is 0.1 to 40 µm, and preferably 0.3 to 30 µm. The thickness of the peeling sheet comprising the adhesion layer is 5.5 to 200 µm, and preferably 10.0 to 100 µm.

The adhesion layer is formed on the second support by dissolving or dispersing an adhesion layer composition in a solvent to obtain a coating solution, then coating the coating solution on the support and drying. The solvent includes alcohols (ethanol, propanol), cellosolves (methyl cellosolve, ethyl cellosolve), aromatic solvents (toluene, xylene, chlorobenzene), ketones (acetone, methylethyl ketone), esters (ethylacetate, butylacetate), ethers (tetrahydrofurane, dioxane), halogenated solvents (chloroform, dichlorobenzene), amide type solvents (dimethylformamide, N-methylpyrrolidone) and dimethylsulfoxide. The layer composition is hot melted and the melted composition can be extrusion coated by an extrusion method.

The image forming material in the invention is prepared preferably by laminating the peeling sheet on the imaging sheet so that the adhesion layer of the peeling sheet is in contact with the image forming layer of the imaging sheet.

### (Lamination of peeling sheet on imaging sheet)

Lamination of the peeling sheet on the imaging sheet can be carried out by applying pressure or by applying heat-pressure. Any pressure or heat-pressure method can be used without any limitations so long as the pressure or heat-pressure can be applied air-tightly. The pressure can be applied by means of a pressure roller or a stamper, and the heat-pressure can be applied by means of a thermal head, a heat roller or a hot stamp.

When the pressure roller is employed, the pressure is usually 0.1 to 20 kg/cm, and preferably 0.5 to 10 kg/cm and the transport speed is usually 0.1 to 200 mm/sec., and preferably 0.5 to 100 mm/sec. When the stamper is employed, the pressure is usually 0.05 to 10 kg/cm, and preferably 0.5 to 5 kg/cm and the pressure time is usually 0.1 to 50 seconds, and preferably 0.5 to 20 seconds. The thermal head is used under conditions usually applied in the conventional fusible or sublimation transfer process. When the heat roller is employed, the heat temperature is usually 60 to 200 °C, and preferably 65 to 180 °C, the pressure is usually 0.1 to 20 kg/cm, and preferably 0.5 to 10 kg/cm and the transport speed is usually 0.1 to 200 mm/sec., and preferably 0.5 to 100 mm/sec. When the hot stamper is employed, the heat temperature is usually 60 to 200 °C, and preferably 65 to 150 °C, the pressure is usually 0.05 to 10 kg/cm, and preferably 0.5 to 5 kg/cm and the pressure time is usually 0.1 to 50 seconds, and preferably 0.5 to 20 seconds.

The peeling layer can be provided on the image forming layer by coating or hot melt extruding a self-supporting resin.

### (Weak adhesion portion, non-contact portion and cutout)

The image forming material in the invention is in a sheet form, and the image forming sheet has a weak adhesion portion or a non-contact portion with a specific length at the leading edge in a transport direction, or has a cutout at both or either of the imaging sheet and the peeling sheet at the leading edge in a transport direction. The non-contact herein referred to implies that, in the image forming material in the invention, the first support is not in contact with the second support or the adhesion layer, or the image forming layer is not in contact with the second support or the adhesion layer. The weak adhesion herein referred to implies that, in the image forming material in the invention, the image forming layer is weakly adhered to the adhesion layer. The weak adhesion force between the image forming layer and the adhesion layer is 0.1 to 15 g/cm, and preferably 0.2 to 10 g/cm. The adhesion force at portions for an image to be formed between the image forming layer and the adhesion layer is 1 to 30 g/cm, and preferably 2 to 20 g/cm. The weak adhesion force is preferably 1/10 to 1/2 of the adhesion force at portions for an image to be formed. The adhesion force or weak adhesion force herein referred to is obtained by measuring three times by a 90° peeling method according to JIS Standard Z 0237 to obtain the average. The length of the weak adhesion portion or non-contact portion is preferably 2 to 30 mm, and more preferably 5 to 20 mm. The length should be the same over the entire width of the sheet. If not so, there occurs a problem in a transporting step, a step of winding around a drum of the image forming sheet or a peeling step. The cutout is preferably formed on the imaging sheet side. The size, number or position of the cutout is optionally selected depending on the size of the image forming sheet. The image forming material in the invention preferably has the cutout.

The image forming sheet in the invention is ordinarily accommodated in a tray or a cartridge. The image forming sheet is taken out of the tray or the cartridge, from the uppermost sheet successively.

### 〈Image forming method〉

The image forming method comprises the steps of imagewise exposing to a high density energy light the above described image forming material, whereby adhesion force at exposed portions between the first support and the image forming layer is reduced, and separating the peeling sheet from the imaging sheet, whereby an image forming layer at exposed portions is transferred to the peeling sheet side and an image forming layer at non-exposed portions remains on the first support to form an image.

The imagewise exposure using a high density energy light is preferably carried out from the first support side in this image forming method. The imagewise exposure is preferably carried out to reduce or lose only the adhesion force between the first support and the image forming layer without destroying the image forming layer, since the exposed portions of the image forming layer can be uniformly transferred to the peeling sheet side.

Ablation in the invention includes a phenomenon that when the image forming material is exposed to light, only the adhesion force between the first support and the image forming layer is reduced or lost, a part of the exposed image forming layer is heat destroyed or released, or cracks occur at exposed portions of the image forming layer, without destroying the image forming layer at the exposed portions.

Any light source can be used without any limitations, so long as it is a light source capable of reducing an adhesion force between the image forming layer and the first support. In order to obtain a high resolving power, the light source is preferably an electromagnetic wave capable of making the energy spots smaller, particularly, a UV light having 1 nm to 1 mm wavelength, a visible light or an infrared light. Such a high density energy light includes, for example, a laser light, an emission diode, a xenon flush lamp, a halogen lamp, a carbon arc light, a metal halide lamp, a tungsten lamp, a quarts mercury lamp and a high pressure mercury lamp.

When an entire exposure is carried out using the high density energy light, the exposure is carried out through a mask material having a negative pattern made of a light shielding material.

When an array light such as an emission diode array is used or exposure using a halogen lamp, a metal halide lamp or a tungsten lamp is controlled using an optical shutter material such as liquid crystal or PLZT, a digital exposure according to an image signal is possible, and direct writing is possible without using the mask material.

However, this method requires additional optical shutter beside the light source. Therefore, the digital exposure is preferably carried out using a laser light.

When the laser light is used, the light can be condensed in the beam form and a latent image is formed using a scanning exposure according to an image. The laser light is easy to condense the exposure spots in small size and therefore, a highly dissolved image can be obtained. The laser light used in the invention is well known. The laser source includes solid lasers such as a ruby laser, a YAG laser, a glass laser, a gas laser such as a He-Ne laser, a Ar laser, a Kr laser, a C0₂ laser, a CO laser, a He-Cd laser, a N₂ laser, an eximer laser, an semiconductor laser such as a InGaP laser, a AlGaAs laser, a GaAsP laser, a InGaAs laser, a InAsP laser, CdSnP₂ laser or a GaSb laser, a chemical laser, and a dye laser. Of these laser light sources, a laser having a 600 to 1200 nm wavelength is preferable in sensitivity in order to produce effectively abrasion, since a light energy can be effectively converted to a heat energy.

The image forming material is optionally subjected to pressure or heat-pressure application after exposure. The pressure or heat-pressure application can be carried out by the methods described above.

### [EMBODIMENTS OF THE INVENTION]

The embodiments of the invention are hereunder explained employing Figs. 1 through 9, but the scope of the invention is by no means limited to them.

A method of separating a peeling sheet includes a method of employing a claw, an adsorption roller or their combination.

Fig. 1 shows one embodiment of the image forming material in the invention, in which a non-contact portion is provided at the edge. The image forming material 100 is comprised of an imaging sheet 8 comprising a first support 1 and provided thereon, an image forming layer 2, and a peeling sheet 9 comprising a second support 4 and provided thereon, an adhesion layer 3. The image forming material has non-contact portions 5 and 6 at the leading edge. As is shown in Fig. 3, a method of forming an image using image forming material 100 comprises the steps of passing the image forming material between a pair of transporting rollers 10, inserting a claw 11, which is provided downstream of the transporting rollers, at the non-contact portion between the imaging sheet 8 and the peeling sheet 9, and separating the peeling sheet 9 while the transporting rollers are rotated. The separated peeling sheet is further passed between the peeling rollers 21 (for peeling sheet) to continue separation. Thus, an imaging sheet with an image is obtained according to this method.

As is shown in Fig. 4, the image forming method comprises the steps of passing the image forming material 100 between the transporting rollers 10, bringing the peeling sheet 9 of the image forming material into contact with an adsorption roller 13, and adsorbing the peeling sheet on the adsorption roller in conjunction with rotation of the roller to separate the peeling sheet. The adsorption roller includes a vacuum roller, an electrostatically attracting roller and an adhesion roller. The peeling sheet 9 separated from the imaging sheet 8 is peeled from the adsorption roller by a claw 14 or by removal of the adsorption force. The resulting peeling sheet is further passed between the peeling rollers 21 (for peeling sheet) to continue separation, transported to an unillustrated dust box, and discarded after a predetermined amount of accumulation. In Fig. 4, nip roller 12 applies pressure to the image forming material, concerted with adsorption roller 13, to obtain a high quality image on the imaging sheet after the separation.

As is shown in Fig. 4(2), hollow adsorption roller 13' with through-hole 30 is used. The peeling sheet 9 is adsorbed at the through-hole 30 of adsorption roller 13', separated in conjunction with rotation of the roller, and when the through-hole 30 comes at pressure roller 31, the adsorption force of the adsorption roller 13' is removed and transported to the peeling rollers 21 to continue separation.

In order to secure a perfect separation, as is shown in Fig. 5, a combination of the adsorption roller 13 and the claw 11 can be used. That is, the support side of the peeling sheet 9 is adsorbed on the adsorption roller 13, and the lifted peeling sheet is forced to be peeled by the claw 11. A claw 14, which prevents the peeling sheet from adhering to the adsorption roller, can be provided. The peeling sheet separated from the imaging sheet 8 by the adsorbing roller can be further peeled from the adsorption roller by the claw 14 or by removal of the adsorption force to discard.

Fig. 2 shows another embodiment of the image forming material 100 in the invention, which has a cutout 7 at the edge. A method of forming an image using this image forming material is shown in Figs. 6(1) and 6(2). In Fig. 6(1), the image forming material is passed between a pair of transporting rollers 10, and brought into contact with an upstream claw 23 to stop the material, and in Fig. 6(2), then the peeling sheet 9 is pushed by the claw 23 to create a space between the imaging sheet 8 and the peeling sheet 9, then the claw 11 is inserted into the space to separate the peeling sheet from the imaging sheet in conjugation with rotation of the transporting rollers. Thus, an imaging sheet with an image is obtained.

In order to secure a perfect separation, as shown in Fig. 7, a combination of the adsorption roller and the claw can be used. That is, the peeling sheet 9 is pushed by the upstream claw 23 from the support side to create a space between the imaging sheet 8 and the peeling sheet 9, the peeling sheet 9 separated is adsorbed on the adsorption roller 13, and further claw 11 is inserted into the space to separate the peeling sheet from the imaging sheet in conjugation with rotation of the transporting rollers. Claw 14, which prevents the peeling sheet from adhering to the adsorption roller, may be further provided. The separated peeling sheet may be separated from the adsorption roller by a claw or by removal of the adsorption force to obtain an imaging sheet having an image.

Next, a direct separating method from a drum is explained.

One separating method will be explained using Fig. 8. The image forming material as shown in Fig. 1, is wound around the rotary drum 16, the imaging sheet 8 side facing outwardly, and imagewise exposed to laser emitted from a laser head 15. Thereafter, a retainer (b) 18 of the edge of the exposed material is released, the drum is rotated counter-clockwise, and the released edge of the material is caught by the claw 11. The imaging sheet 8 is inserted between peeling rollers 22 (for imaging sheet), and separation by the claw proceeds due to rotation of the rotary drum. When the retainer (a) 17 approaches the claw 11, the retainer (a) 17 is released, and the imaging sheet is completely separated from the peeling sheet to obtain an imaging sheet having an image. During separating, the peeling sheet 9 is preferably drawn to the drum by suction due to reduced pressure or electrostatic attraction. After the imaging sheet with an image is obtained, the peeling sheet is released from the drum, and discarded.

In Fig. 9(1), a retainer (a) 17, a retainer (b) 18 and a retainer (c) 19 are provided on the rotary drum 16, except for the cutout 7 of the image forming material of Fig. 2. In Fig. 9(2), the image forming material is wound around the rotary drum 16, the imaging sheet 8 side facing outwardly, and imagewise exposed to laser emitted from a laser head 15, and then the retainer (b) 18 is released. Thereafter, the drum 16 is rotated counter-clockwise, and a claw 20 is inserted between the imaging sheet and the retainer (c) 19. Then, claw 20 is inserted between the imaging sheet 8 and the peeling sheet 9 while the drum is slowly rotated, and the separated imaging sheet passes between the peeling rollers 22 (for imaging sheet) to continue separation. When the retainer (a) 17 approaches the claw 20, the retainer is released, and the imaging sheet is completely separated from the peeling sheet. During separating, the peeling sheet is preferably adsorbed on the drum by suction due to reduced pressure or by electrostatic attraction. After an imaging sheet with an image is obtained, all the retainers are released, and adsorption force applied to the drum is removed to discard the peeling sheet.

### [EFFECTS OF THE INVENTION]

According to the present invention, the non-contact portion or weak adhesion portion at the edge of the image forming material provides easy separating of the peeling sheet from the imaging sheet.

Further, the cutout portion at the edge of the image forming material enhances easier separating of the peeling sheet from the imaging sheet.

Easy separating according to the method of the invention provides a compact image forming apparatus, since claws can be provided near the rotary drum.

## Claims

1. An image forming method comprising the steps of:
imagewise exposing a heat sensitive image forming material in a sheet form to a high density energy light, the material comprising an imaging sheet having an image forming layer on a first support and a peeling sheet having an adhesion layer on a second support, the imaging sheet being laminated on the peeling sheet so that the image forming layer is in contact with the adhesion layer, and a weak adhesion portion or a non-contact portion being provided at the leading edge of the material in a transport direction;
inserting a claw between the imaging sheet and the peeling sheet; and
separating the imaging sheet from the peeling sheet to form an image on the imaging sheet.

2. The image forming method of claim 1, wherein the imaging sheet is different in a length in the transport direction from the peeling sheet.

3. The image forming method of claim 1, wherein the length in the transport direction of the non-contact portion in the transport direction is 2 to 30 mm.

4. The image forming method of claim 1, wherein the length in the transport direction of the weak adhesion portion is 2 to 30 mm.

5. The image forming method of claim 1, wherein the image forming layer contains a colorant in an amount of 10 to 99 weight % and a binder in an amount of 1 to 90 weight %.

6. The image forming method of claim 1, wherein the thickness of the image forming layer is 0.05 to 5.0 µm.

7. The image forming method of claim 1, wherein the thickness of the adhesion layer is 0.1 to 40 µm.

8. An image forming method comprising the steps of:
imagewise exposing a heat sensitive image forming material in a sheet form to a high density energy light, the material comprising an imaging sheet having an image forming layer on a first support and a peeling sheet having an adhesion layer on a second support, the imaging sheet being laminated on the peeling sheet so that the image forming layer is in contact with the adhesion layer, and a cutout being provided at the leading edge in a transport direction of at least one of the imaging sheet and the peeling sheet;
pushing the cutout to create a space between the imaging sheet and the peeling sheet; and
separating the imaging sheet from the peeling sheet to form an image on the imaging sheet.

9. The image forming method of claim 8, wherein the cutout is provided at the imaging sheet.

10. The image forming method of claim 8, wherein the separating is carried out by inserting a claw at the space between the imaging sheet and the peeling sheet.
